# EUROPEAN PATENT APPLICATION

(11) **EP 4 144 896 A1**
(43) Date of publication of application: **08.03.2023**
(21) Application number: 21795307.4
(22) Date of filing: 27.04.2021
(51) Int. Cl.: C30B 25/18, B23K 26/53, H01L 21/02, H01L 21/20, H01L 21/306, H01L 21/50, H01L 21/683, C30B 29/38

(54) **METHOD FOR MANUFACTURING SEMICONDUCTOR ELEMENT**

(30) Priority: 28.04.2020 JP 2020079547; 25.06.2020 JP 2020110022
(71) Applicant: Kyocera Corporation, Kyoto-shi Kyoto 612-8501 (JP)
(72) Inventor: NISHIMURA, Takehiro, Kyoto-shi, Kyoto 612-8501 (JP)
(74) Representative: Viering, Jentschura & Partner mbB Patent- und Rechtsanwälte
(86) International application number: PCT/JP2021/016802
(87) International publication number: WO 2021/221055

(57) **Abstract**

In a manufacturing method of a semiconductor element of the present disclosure, a first semiconductor part (SL1) includes a protruding portion (TS) protruding toward an underlying substrate (UK), the protruding portion contains a nitride semiconductor, the protruding portion and the underlying substrate are bonded to each other, a semiconductor substrate (HK) includes a hollow portion (TK) located between the underlying substrate and the first semiconductor part, the hollow portion is in contact with a side surface of the protruding portion and communicates with the outside of the semiconductor substrate, and the protruding portion (TS) is irradiated with the laser beam (LZ) before the first semiconductor part is separated from the semiconductor substrate.

## Description

### TECHNICAL FIELD

The present invention relates to a manufacturing method of a semiconductor element.

### BACKGROUND OF INVENTION

In a manufacturing method of a semiconductor element, various techniques for separating a semiconductor layer formed on a substrate from the substrate have been proposed (see, for example, Patent Document 1 below).

### CITATION LIST

### PATENT LITERATURE

Patent Document 1: JP 4638958 B

### SUMMARY

A manufacturing method of a semiconductor element of the present disclosure includes forming a plurality of semiconductor layers above a first surface of an underlying substrate by epitaxial growth, semiconductor layers adjacent to each other in a direction along the first surface among the plurality of semiconductor layers being at least partially separated from each other in the direction along the first surface, weakening a connecting portion between each of the plurality of semiconductor layers and the first surface by irradiating the connecting portion with a laser beam, and separating the plurality of semiconductor layers from the underlying substrate.

### BRIEF DESCRIPTION OF THE DRAWINGS

FIG. 1 is a view for describing a manufacturing method of semiconductor elements according to an embodiment of the present disclosure.
FIG. 2 is a view for describing forming steps in the manufacturing method of the semiconductor elements according to an embodiment of the present disclosure.
FIG. 3 is a plan view illustrating pattern shapes of a plurality of semiconductor layers formed on an underlying substrate.
FIG. 4 is a view for describing a variation of a separating step in the manufacturing method of the semiconductor elements according to an embodiment of the present disclosure.
FIG. 5 is a flowchart illustrating each step in the manufacturing method of the semiconductor elements according to an embodiment of the present disclosure.
FIG. 6A is a cross-sectional view illustrating a state in which the semiconductor elements are formed above the underlying substrate via a mask layer.
FIG. 6B is a cross-sectional view illustrating a state in which the mask is removed.
FIG. 6C is a cross-sectional view for describing a step of weakening connecting portions.
FIG. 7 is a plan view illustrating a pattern shape of the mask.
FIG. 8A is a cross-sectional view for describing the separating step.
FIG. 8B is a cross-sectional view for describing the separating step.
FIG. 8C is a cross-sectional view for describing the separating step.
FIG. 9A is a cross-sectional view illustrating an etching shape of one of the connecting portions.
FIG. 9B is a cross-sectional view illustrating an etching shape of one of the connecting portions.
FIG. 9C is a cross-sectional view illustrating an etching shape of one of the connecting portions.
FIG. 10 is a cross-sectional view illustrating a manufacturing method of semiconductor elements according to a third embodiment.
FIG. 11 is a cross-sectional view illustrating the manufacturing method of the semiconductor elements according to the third embodiment.
FIG. 12 is a cross-sectional view illustrating configuration examples of the underlying substrate.
FIG. 13 is a plan view illustrating a configuration example of a semiconductor substrate.

### DESCRIPTION OF EMBODIMENTS

### First Embodiment

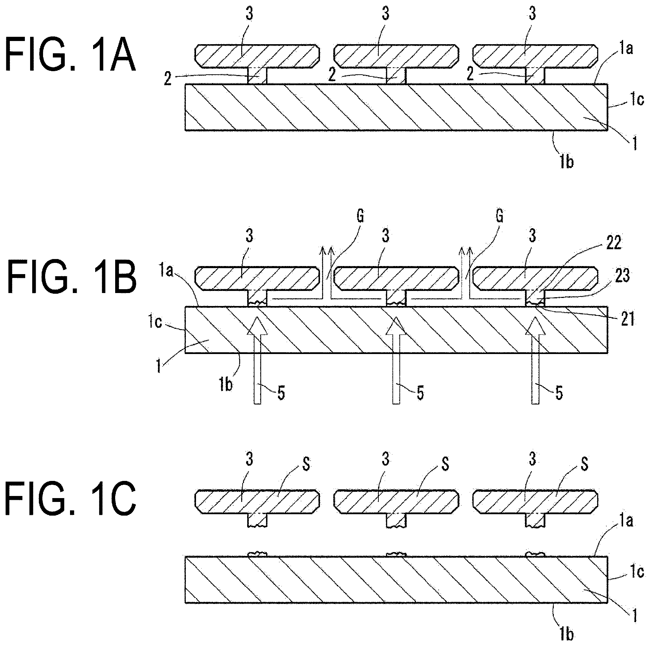

A first embodiment of the present disclosure will be described below with reference to the drawings. The drawings are schematically depicted for ease of illustration. Description will be given with reference to FIGs. 1 to 4.

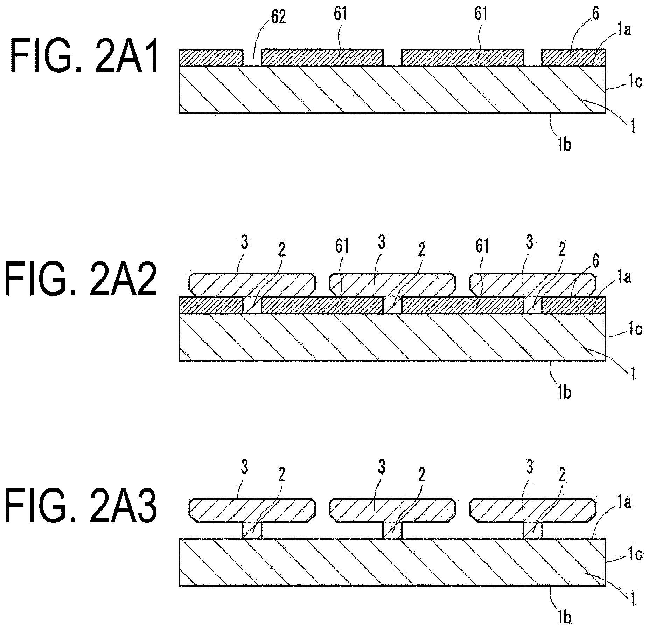

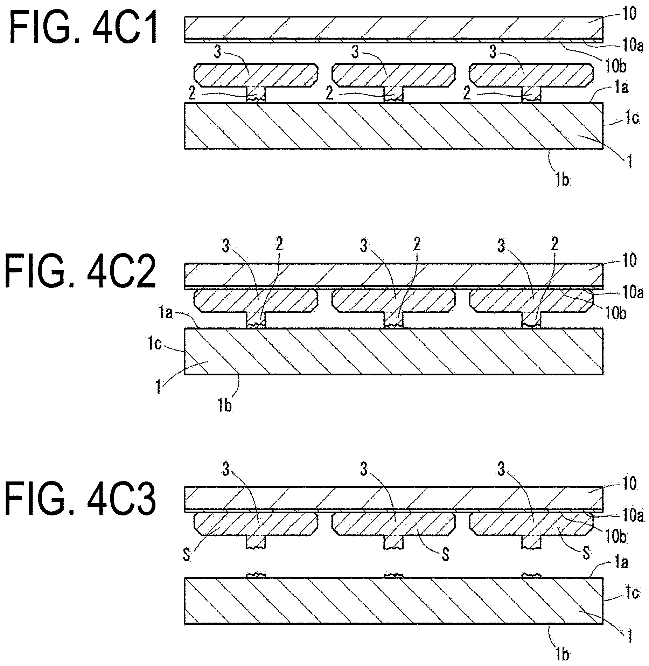

In FIG. 1, "step a" indicates a forming step, "step b" indicates a weakening step, and "step c" indicates a separating step. In FIG. 2, "step a1" indicates a mask forming step, "step a2" indicates a semiconductor layer forming step, and "step a3" indicates a mask removing step. In FIG. 4, "step c1" indicates a preparing step, "step c2" indicates a bonding step, and "step c3" indicates a peeling step.

The manufacturing method of the semiconductor element of the present embodiment includes the forming step a, the weakening step b, and the separating step c. The forming step a is a step of forming a plurality of semiconductor layers 3 above an underlying substrate 1 by, for example, an epitaxial lateral overgrowth (ELO) method, which is one of an epitaxial vapor phase growth, each of the plurality of semiconductor layers 3 being connected to the underlying substrate 1 by a connecting portion 2. The weakening step b is a step of irradiating the connecting portion 2 with a laser beam 5 to weaken the connecting portion 2. The separating step c is a step of separating the plurality of semiconductor layers 3 from the underlying substrate 1.

In each of the plurality of semiconductor layers 3, for example, a cleavage surface is formed, and an electrode, a wiring conductor, and the like are arranged, so that one or a plurality of semiconductor elements S are formed. Examples of the semiconductor element S include a light emitting diode (LED), a semiconductor laser (laser diode (LD)), and a photodiode (PD), but are not limited thereto.

The underlying substrate 1 includes one main surface (hereinafter, also referred to as a first surface) 1a that is flat and includes a starting point of growth of a semiconductor crystal, another main surface (hereinafter, also referred to as a second surface) 1b that is flat and is on the opposite side of the first surface 1a, and a side surface (hereinafter, also referred to as a third surface) 1c connecting the first surface 1a and the second surface 1b. In the underlying substrate 1, at least the first surface 1a is made of a nitride semiconductor. The underlying substrate 1 may be a substrate made of, for example, a nitride semiconductor such as gallium nitride (GaN), aluminum gallium nitride (AlGaN), and indium gallium nitride (InGaN).

The underlying substrate 1 used in the present embodiment is a GaN substrate cut out from a GaN single crystal ingot. The underlying substrate 1 is cut out from the single crystal ingot such that the first surface 1a including the starting point of growth of the semiconductor crystal is in a predetermined plane direction. The underlying substrate 1 may be an n-type substrate obtained by doping GaN with impurities of Si or the like or a p-type substrate obtained by doping GaN with impurities of Mg or the like. The impurity density of the underlying substrate 1 is, for example, about 1 × 10¹⁹ cm⁻³ or less.

### (a) Forming Step

The forming step a is a step of forming the plurality of semiconductor layers 3 above the first surface 1a of the underlying substrate 1 by the ELO method. In the forming step a, the plurality of semiconductor layers 3 are formed such that semiconductor layers 3 adjacent to each other in a direction along the first surface 1a among the plurality of semiconductor layers 3 are at least partially separated from each other in the direction along the first surface 1a.

The forming step a includes a mask forming step a1, a semiconductor layer forming step a2, and a mask removing step a3 described below.

### (a1) Mask Forming Step

The mask forming step a1 is a step of forming a deposition suppression mask (hereinafter, also referred to simply as "mask") 6 on the underlying substrate 1, the mask 6 suppressing crystal of the semiconductor crystal. In the mask forming step a1, for example, approximately 100 nm of silicon oxide (for example, SiO₂) serving as a material of the mask 6 is first deposited on the first surface 1a of the underlying substrate 1 by a plasma chemical vapor deposition (PCVD) method or the like. Next, for example, the silicon oxide layer is patterned by a photolithography method and wet etching with buffered hydrogen fluoride (BHF). In this manner, the mask 6 is formed in a predetermined pattern on the first surface 1a.

The mask 6 may have a stripe shape in which a plurality of strip shape portions 61 are arranged in parallel at a predetermined interval, for example. A width of an opening portion 62, which is also referred to as a mask window, between adjacent two of the plurality of strip shape portions 61 is, for example, approximately from 2 µm to 20 µm. The width of each of the plurality of strip shape portions 61 is, for example, approximately from 50 µm to 200 µm.

The mask 6 may also cover an edge region near the third surface 1c on the first surface 1a of the underlying substrate 1. This allows one of the plurality of the semiconductor layers 3 that is grown in the edge region of the first surface 1a to be neatly and reliably separated from the underlying substrate 1. Further, abnormal growth of the semiconductor crystal in the edge region of the first surface 1a can be suppressed.

### (a2) Semiconductor Layer Forming Step

In the semiconductor layer forming step a2, GaN crystal is vapor phase grown from a region that is not covered by the mask 6 and exposed to the opening portion 62 on the first surface 1a of the underlying substrate 1.

As a method for growing the semiconductor crystal, for example, vapor phase epitaxy (VPE) by a chloride transport method using a chloride as a group III raw material, or metal organic chemical vapor deposition (MOCVD) using an organic metal as a group III raw material can be used. For example, the ratio of raw material gas of a group III element, the ratio of raw material gas of an impurity, and the like are changed during the growth of the GaN crystal, and thus each of the plurality of semiconductor layers 3 can be formed as a multi-layer film functioning as a light emitting diode (LED), a semiconductor laser (laser diode (LD)), or the like.

When the semiconductor crystal is grown beyond the opening portion 62 of the mask 6, the semiconductor crystal is also grown in the lateral direction along the upper surface of the mask 6. The growth of the semiconductor crystal may be completed before the semiconductor crystal grown from the first surface 1a overlaps with an adjacent semiconductor crystal. In this manner, for example, as illustrated in FIGs. 1 and 2, each of the plurality of semiconductor layers 3 connected to the first surface 1a by the connecting portion 2 is obtained. The connecting portion 2 is made of, for example, GaN crystal, in a manner similar to each of the plurality of semiconductor layers 3. The connecting portion 2 has, for example, a width approximately from 2 µm to 20 µm and a height approximately from 100 nm to 500 nm. Each of the plurality of semiconductor layers 3 has, for example, a width approximately from 50 µm to 200 µm and a height approximately from 10 µm to 50 µm. The growth of the semiconductor crystal may be continued until the semiconductor crystal laterally grown along the upper surface of the mask 6 overlaps with the adjacent semiconductor crystal. In this case, a semiconductor layer connected to the first surface 1a by a plurality of connecting portions 2 is obtained.

### (a3) Mask Removing Step

The mask removing step a3 is a step of removing the mask 6 after the completion of the semiconductor layer forming step a2. In the mask removing step a3, the underlying substrate 1 above which the plurality of semiconductor layers 3 is formed is taken out from a vapor phase growth device (epitaxial device), and then the mask 6 is removed by using an etchant not substantially damaging the plurality of semiconductor layers 3.

For example, when the mask 6 is made of a silicon oxide film, wet etching using BHF is performed to remove the mask 6. In this manner, for example, as illustrated in FIG. 1, each of the plurality of semiconductor layers 3 connected to the first surface 1a by the connecting portion 2 can be obtained.

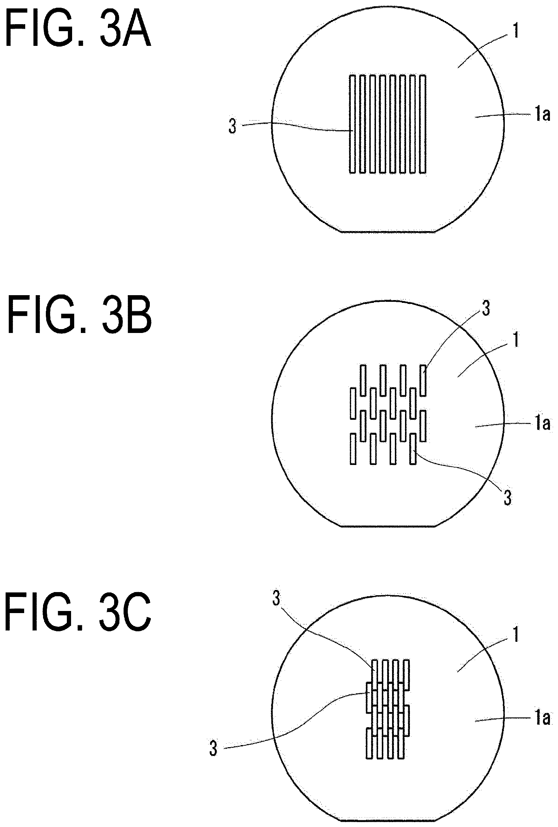

Each of the plurality of semiconductor layers 3 may extend in a predetermined direction in a plan view. The plurality of semiconductor layers 3 may form a pattern, for example, as illustrated in FIG. 3 in a plan view. The plurality of semiconductor layers 3 may form a stripe shape pattern extending in a predetermined direction, for example, as illustrated in FIG. 3A. The plurality of semiconductor layers 3 may be arranged in a staggered manner to form a so-called repeat design pattern, for example, as illustrated in FIG. 3B. The plurality of semiconductor layers 3 may form a grid-like pattern in which each of the plurality of semiconductor layers 3 is connected, at both end portions thereof, to adjacent semiconductor layers 3, for example, as illustrated in FIG. 3C.

### (b) Weakening Step

The weakening step b is a step of irradiating the connecting portion 2 with the laser beam 5 to weaken the connecting portion 2. In the weakening step b, for example, irradiation with the laser beam 5 can thermally denature the connecting portion 2 to change the crystal structure of the connecting portion 2. This generates, for example, a crack, a fracture, or the like in the connecting portion 2 to reduce a mechanical strength of the connecting portion 2. In the weakening step b, the irradiation with the laser beam 5 may completely or partially cut the connecting portion 2.

The wavelength of the laser beam 5 may be, for example, 370 nm or less. As a light source for outputting the laser beam 5, for example, an AlGAN-based semiconductor laser, a KrF excimer laser, an ArF excimer laser, and a YAG laser (third harmonic) can be used. A focal length and a spot size of the laser beam 5 can be selected as appropriate depending on the dimensions and the like of the underlying substrate 1, each connecting portion 2, and each of the plurality of semiconductor layers 3.

Irradiation with the laser beam 5 may be performed from a direction of the first surface 1a of the underlying substrate 1, or may be performed from a direction of the second surface 1b of the underlying substrate 1. Irradiation with the laser beam 5 may be performed from a direction of the third surface 1c of the underlying substrate 1.

### (c) Separating Step

The separating step c is a step of separating the plurality of semiconductor layers 3 from the underlying substrate 1. In the separating step c, for example, a blade is brought into contact with each of the plurality of semiconductor layers 3, or the connecting portion 2 is irradiated with ultrasonic waves, and thus a force is applied to the weakened connecting portion 2. This can break the connecting portion 2 to separate each of the plurality of semiconductor layers 3 from the underlying substrate 1.

In the weakening step b, when the irradiation with the laser beam 5 completely cuts the connecting portion 2, the separating step c can be omitted.

According to the manufacturing method of the semiconductor element of the present embodiment, among the plurality of semiconductor layers 3 formed above the first surface 1a of the underlying substrate 1, semiconductor layers 3 adjacent to each other in the direction along the first surface 1a are at least partially separated from each other in the direction along the first surface 1a. Thus, decomposition product gas, evaporated gas, or the like that is generated by irradiating the connecting portion 2 with the laser beam 5 and that fills a space between each of the plurality of semiconductor layers 3 and the underlying substrate 1 can be released to the outside. The gas can be released to the outside through each gap (hereinafter, also referred to as release path) G between the semiconductor layers 3 adjacent to each other, as indicated by arrows in FIG. 1, for example. This can reduce damage to the plurality of semiconductor layers 3 and the underlying substrate 1 due to the pressure of the decomposition product gas or the evaporated gas. As a result, the semiconductor element S with high-quality can be manufactured. The underlying substrate 1 can be reused without polishing for removing damaged sites or with only a small amount of polishing. This can improve the production efficiency of the semiconductor element S, and provide the semiconductor element S capable of increasing the number of times the underlying substrate 1 can be reused.

In the manufacturing method of the semiconductor element according to the present embodiment, the entirety of the underlying substrate 1 does not need to be irradiated with the laser beam 5, and only the connecting portion 2 connecting each of the plurality of semiconductor layers 3 and the first surface 1a needs to be irradiated. This can suppress excessive heating of each of the plurality of semiconductor layers 3 and the underlying substrate 1 to reduce thermal damage to each of the plurality of semiconductor layers 3 and the underlying substrate 1. As a result, the semiconductor element S with high-quality can be manufactured. The underlying substrate 1 can be reused without polishing for removing damaged sites or with only a small amount of polishing. This can improve the production efficiency of the semiconductor element S and reduce the manufacturing cost of the semiconductor element S.

In the manufacturing method of the semiconductor element according to the present embodiment, since the underlying substrate 1, each connecting portion 2, and each of the plurality of semiconductor layers 3 are made of GaN crystal, the indexes of refraction thereof are substantially the same. This can reduce refraction and reflection of the laser beam 5 at an interface between the underlying substrate 1 and the connecting portion 2 and at an interface between the connecting portion 2 and each of the plurality of semiconductor layers 3. As a result, the connecting portion 2 can be irradiated with the laser beam 5 with high accuracy and high efficiency. This enables manufacture of the semiconductor element S with high-quality. This can also improve the production efficiency of the semiconductor element S.

In the semiconductor layer forming step a2, when the growth of the semiconductor crystals is continued until adjacent semiconductor crystals overlap with each other to form a semiconductor layer connected to the first surface 1a by a plurality of connecting portions 2, a through hole penetrating the semiconductor layer in the thickness direction may be formed before the weakening step b. As a result, decomposition product gas or evaporated gas filling the space between the semiconductor layer and the underlying substrate 1 can be released to the outside through the through hole. As a result, even when the semiconductor layer connected to the first surface 1a by the plurality of connecting portions 2 is formed, the semiconductor element S with high-quality can be manufactured, and the production efficiency of the semiconductor element S can be improved.

In the weakening step b, irradiation with the laser beam 5 may be performed from a direction of the second surface 1b of the underlying substrate 1, and thus the laser beam 5 may be incident on the underlying substrate 1 from the second surface 1b. Since the underlying substrate 1 is not a dissimilar substrate obtained by forming a GaN layer on a surface of a sapphire substrate, an SiC substrate, or the liker, but a substrate made of substantially the same material, the index of refraction of the underlying substrate 1 is substantially constant. Thus, incidence of the laser beam 5 from the second surface 1b of the underlying substrate 1 allows the laser beam 5 to be focused on the connecting portion 2 with high accuracy. Irradiation with the laser beam 5 from a direction of the second surface 1b where no semiconductor layer 3 is formed can reduce the possibility that the irradiation with the laser beam 5 denatures each of the plurality of semiconductor layers 3. Since the index of refraction of the underlying substrate 1 is substantially constant, a lens optical system with a simple configuration can be used as an optical system for concentrating the laser beam 5 onto the connecting portion 2. This can improve the production efficiency of the semiconductor element S. Note that, in the present disclosure, the present description does not exclude a case where the dissimilar substrate such as the sapphire substrate, the SiC substrate, or the like is employed as the underlying substrate 1.

In the weakening step b, the connecting portion 2 may be irradiated with picosecond pulse laser beam or femtosecond pulse laser beam. This can induce ablation phenomenon caused by multi-photon absorption at the connecting portion 2 where the laser beam 5 is focused. Thus, the connecting portion 2 can be weakened with high accuracy while thermal damage in each of the plurality of semiconductor layers 3 and the underlying substrate 1 is suppressed.

In the weakening step b, the connecting portion 2 may be irradiated with a subnanosecond pulse laser beam or a nanosecond pulse laser beam. As a result, the material removal rate increases as compared with a case where the pulse width of the laser beam 5 is picosecond or femtosecond, and thus the machining efficiency in the weakening step b can be improved.

When the pulse width of the laser beam 5 is subnanosecond or nanosecond, a large amount of decomposition product gas or evaporated gas may be generated as compared with a case where the pulse width of the laser beam 5 is picosecond or femtosecond. Optimizing the release path G allows the decomposition product gas and the evaporated gas to be effectively released to the outside even when the pulse width of the laser beam 5 is subnanosecond or nanosecond. For example, as illustrated in FIG. 1, the release path G may be optimized by forming each of the plurality of semiconductor layers 3 having a cross-sectional shape in which corners of a lower surface are rounded. For example, as illustrated in FIG. 3B, the release path G may be optimized by forming the plurality of semiconductor layers 3 arranged in a staggered manner and adjusting the interval between semiconductor layers 3 adjacent to each other among the plurality of semiconductor layers 3 in two directions different from each other.

As a scanning path of the laser beam 5 in the weakening step b, a scanning path to improve the production efficiency of the semiconductor element S is selected in accordance with the pattern shape and the like of the plurality of semiconductor layers 3 formed above the underlying substrate 1. In the weakening step b, for example, scanning with the laser beam 5 may be performed from an outer peripheral portion of the underlying substrate 1 toward a central portion of the underlying substrate 1 while the underlying substrate 1 rotates around an axis perpendicular to the first surface 1a. Accordingly, the concentrating point of the laser beam 5 does not need to reciprocate a plurality of times, and thus the time required for the weakening step b can be shortened. This can improve the production efficiency of the semiconductor element S.

In the weakening step b, heating the underlying substrate 1 may maintain the temperature of the underlying substrate 1 within a predetermined temperature range. As a result, Ga metal precipitated by the irradiation with the laser beam 5 is brought into a molten state so as not to easily adhere to the plurality of semiconductor layers 3. This can maintain quality of the plurality of semiconductor layers 3. The predetermined temperature range may be, for example, around room temperature (approximately from 15°C to 35°C) or more and 300°C or less.

In the weakening step b, the atmosphere, pressure, and the like in the laser processing device may be adjusted for suppression of oxidation of the underlying substrate 1 having a high temperature due to the irradiation with the laser beam 5, and oxidation of the Ga metal precipitated due to the irradiation with the laser beam 5. This can reduce damage to the underlying substrate 1 due to the oxidation. As a result, the underlying substrate 1 can be reused without polishing for removing damaged portions or with only a small amount of polishing. This can improve the production efficiency of the semiconductor element S and reduce the manufacturing cost of the semiconductor element S. Adhesion of the oxidized Ga metal to the plurality of semiconductor layers 3 can be suppressed, and thus the possibility of decrease in quality of the plurality of semiconductor layers 3 can be reduced. As a result, the semiconductor element S with high-quality can be manufactured.

In the weakening step b, the laser beam 5 may be focused on an end portion 21 of the connecting portion 2 closer to the underlying substrate 1. This can suppress undesired thermal denaturation of each of the plurality of semiconductor layers 3 due to the irradiation with the laser beam 5. As a result, the polishing for removing the thermally-denatured portion of each of the plurality of semiconductor layers 3 can be omitted, or the amount of polishing of each of the plurality of semiconductor layers 3 can be reduced. This can improve the production efficiency of the semiconductor element S.

In the weakening step b, the laser beam 5 may be focused on an end portion 22 of the connecting portion 2 closer to each of the plurality of semiconductor layers 3. This can suppress undesired thermal denaturation of the underlying substrate 1 due to the irradiation with the laser beam 5. As a result, the polishing for removing the thermally-denatured portion of the underlying substrate 1 can be omitted, or the amount of polishing of the underlying substrate 1 can be reduced. This can improve the production efficiency of the semiconductor element S and reduce the manufacturing cost of the semiconductor element S.

In the weakening step b, the laser beam 5 may be focused on an intermediate portion 23 located between the end portion 21 of the connecting portion 2 closer to the underlying substrate 1 and the end portion 22 of the connecting portion 2 closer to each of the plurality of semiconductor layers 3. Thus, undesired thermal denaturation of each of the plurality of semiconductor layers 3 and the underlying substrate 1 can be thus suppressed. This enables manufacture of the semiconductor element S with high-quality, improvement of the production efficiency of the semiconductor element S, and reduction of the manufacturing cost of the semiconductor element S.

When the connecting portion 2 is not fully cut in the weakening step b, the separating step c may include the preparing step c1, the bonding step c2, and the peeling step c3.

The preparing step c1 is a step of preparing a support substrate 10 including a facing surface 10a facing the first surface 1a of the underlying substrate 1. The support substrate 10 includes, on the facing surface 10a, a bonding layer 10b made of solder using a material such as AuSn.

The bonding step c2 is a step of bonding the support substrate 10 on upper surfaces of the plurality of semiconductor layers 3. In the bonding step c2, first, the support substrate 10 is disposed on the plurality of semiconductor layers 3 formed above the underlying substrate 1 in the forming step a. The support substrate 10 is disposed such that the facing surface 10a faces the first surface 1a of the underlying substrate 1. Subsequently, the support substrate 10 is heated while being pressed toward the underlying substrate 1 and bonded to the upper surfaces of the plurality of semiconductor layers 3.

The peeling step c3 is a step of peeling the plurality of semiconductor layers 3 from the underlying substrate 1. In the peeling step c3, the underlying substrate 1 and the support substrate 10 are relatively separated from each other. This generates a tensile stress in the connecting portion 2 weakened by the irradiation with the laser beam 5 to break the connecting portion 2, allowing the plurality of semiconductor layers 3 to be separated from the underlying substrate 1. Each of the plurality of semiconductor layers 3 can be peeled off from the underlying substrate 1 without being damaged by weakening the connecting portion 2. The peeling step c3 may include a step of forming the cleavage surface in each of the plurality of semiconductor layers 3 and a step of forming an electrode, a wiring conductor, or the like on each of the plurality of semiconductor layers 3.

Note that the preparing step c1 and the bonding step c2 may be performed between the forming step a and the weakening step b. In this case, the decomposition product gas or the evaporated gas generated by the irradiation with the laser beam 5 flows along the first surface 1a toward an outer edge portion of the underlying substrate 1 in the space between each of the plurality of semiconductor layers 3 and the underlying substrate 1 and is released to the outside. In the support substrate 10, a gas channel (not illustrated) for promoting release of the decomposition product gas or the evaporated gas to the outside may be formed. The gas channel may be, for example, a through hole penetrating the support substrate 10 in the thickness direction. The gas channel may be, for example, a groove portion formed on the facing surface 10a of the support substrate 10.

The manufacturing method of a semiconductor element of the present disclosure includes a step of forming a plurality of semiconductor layers above a first surface of an underlying substrate by epitaxial growth, semiconductor layers adjacent to each other in a direction along the first surface among the plurality of semiconductor layers being at least partially separated from each other in the direction along the first surface, a step of weakening a connecting portion between each of the plurality of semiconductor layers and the first surface by irradiating the connecting portion with a laser beam, and a step of separating the plurality of semiconductor layers from the underlying substrate.

There is room for improvement in a method for separating a plurality of semiconductor layers from a substrate in order to produce a semiconductor element with good quality.

According to the manufacturing method of the semiconductor element of the present disclosure, the damage to the underlying substrate and the plurality of semiconductor layers can be reduced when the plurality of semiconductor layers are separated from the underlying substrate. This allows the plurality of semiconductor elements with high quality to be manufactured, and the production efficiency of the plurality of semiconductor elements to be improved.

### Second Embodiment

Other embodiments of the present disclosure will be described below with reference to each drawing schematically illustrated.

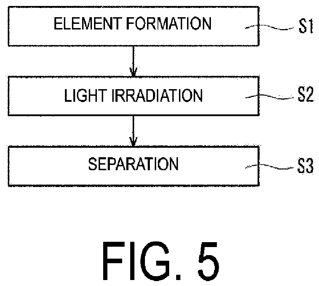

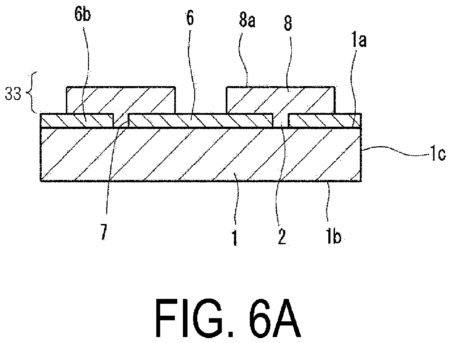

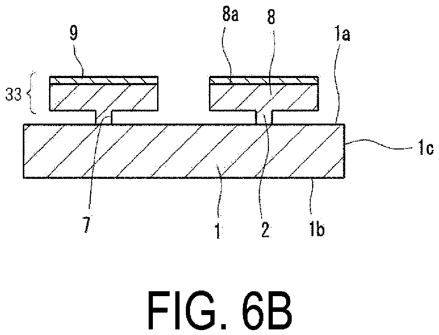

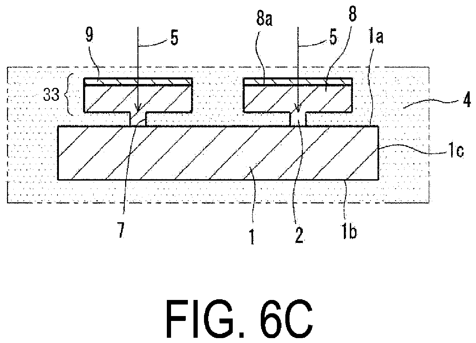

As illustrated in FIG. 5, the manufacturing method of the semiconductor element of the present embodiment includes element forming step S1, light irradiation step S2 (or also referred to as a weakening step), and separating step S3. As illustrated in FIGs. 6A, 6B, and 6C, the element forming step S1 is a step of forming each semiconductor element 33 coupled by a connecting portion 2 on an underlying substrate 1 by an ELO method. The light irradiation step S2 is a step of bringing the connecting portion 2 into contact with an etching solution 4 and irradiating at least a part of the connecting portion 2 with light such as a laser beam 5 to dissolve or weaken the connecting portion 2. The separating step S3 is a step of separating the semiconductor element 33 in which the connecting portion 2 is, for example, weakened by the light irradiation step S2 from the underlying substrate 1.

The element forming step S1 and the light irradiation step S2 do not need to be performed in this order, and for example, the element forming step S1 and the light irradiation step S2 may be performed in parallel. This can shorten the process time. Examples of the semiconductor element 33 include a light emitting diode (LED), a semiconductor laser (laser diode (LD)), and a photodiode (PD), but are not limited thereto.

The underlying substrate 1 includes a first surface 1a, which is one main surface having a flat shape and serving as a start point of the crystal growth of a semiconductor, and a second surface 1b, which is another main surface on the back side of the one main surface and having a flat shape. At least a surface of the first surface 1a is made of a nitride semiconductor. The underlying substrate 1 used in the embodiment is, for example, a gallium nitride (GaN) substrate cut out from a GaN single crystal ingot such that the first surface 1a, which is a growth surface, is in a predetermined plane direction. The GaN substrate may be either an n-type substrate or a p-type substrate in which the semiconductor is doped with impurities such as Si. The GaN substrate having an impurity density of approximately 1 × 10¹⁹ cm⁻³ or less, for example, can be used.

Instead of the GaN substrate, a substrate not made of GaN, such as a sapphire substrate or an SiC substrate, including a GaN layer formed on a front surface thereof may be used as the underlying substrate 1. The surface of the underlying substrate 1 is not limited to a GaN layer, and any substrate made of a GaN-based semiconductor may be used. Here, "nitride semiconductor" refers to a semiconductor made of AlₓGa_{y}In_{z}N (0 ≤ x ≤ 1; 0 ≤ y ≤ 1; 0 ≤ z ≤ 1; 1).

The mask 6 is formed on the above-described underlying substrate 1. As to the mask 6, for example, approximately 100 nm of silicon oxide (for example, SiO₂) serving as a material of the mask 6, is deposited on the first surface 1a of the underlying substrate 1 by a plasma chemical vapor deposition (PCVD) method or the like. Subsequently, for example, the SiO₂ layer is patterned by a photolithography method and wet etching with buffered hydrofluoric acid (BHF). Thus, the mask 6 illustrated in FIG. 6A is formed.

The mask 6 has a stripe shape in which a plurality of strip shape portions 6a are arranged in parallel at a predetermined interval. A width of an opening portion 7, which is also referred to as a mask window, between adjacent two of the plurality of strip shape portions 6a is, for example, approximately from 2 µm to 20 µm. The width of each of the plurality of strip shape portions 6a is, for example, approximately from 50 µm to 200 µm.

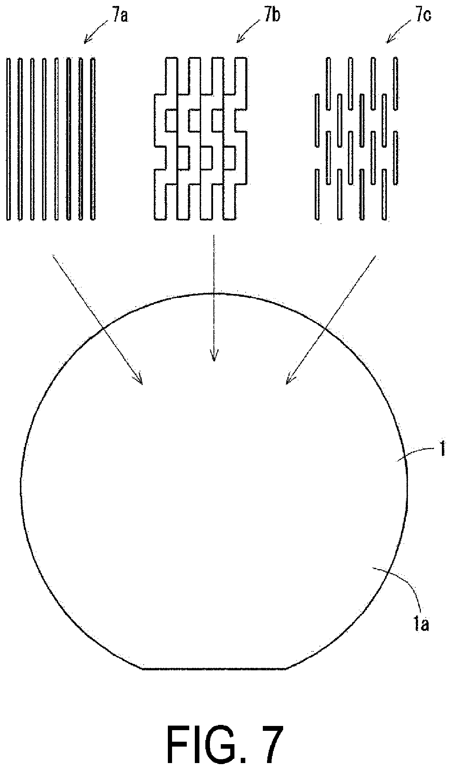

FIG. 7 is a plan view illustrating a pattern shape of the mask. The mask material for forming the mask 6 may be any material from which a semiconductor layer does not grow by vapor phase epitaxy, in addition to SiO₂. As the mask material, for example, an oxide, such as ZrOx, TiOx, or AlOx, which can be patterned, or a transition metal, such as W or Cr can be used. As the method of stacking the mask layer, any method, such as vapor deposition, sputtering, or coating and curing, which is suitable for the mask material, can be used as appropriate. As a specific example, an SiO₂ layer having a thickness approximately from 100 nm to 500 nm is formed as the mask 6. The SiO₂ layer is formed as follows. First, silicon oxide (SiO₂), which is the material of the mask 6, is deposited on the first surface 1a to have a thickness approximately from 100 nm to 500 nm by the plasma chemical vapor deposition (PCVD) method or the like.

The mask pattern of the mask 6 may be, in addition to the strip shape indicated by a reference sign 7a in FIG. 7, a grid shape indicated by a reference sign 7b in which a plurality of strip-shaped bodies are arranged to be orthogonal to one another lengthwise and crosswise. A so-called repeat design (pattern) indicated by a reference sign 7c, in which a plurality of the opening portions 7 partitioned at a constant interval (repeat pitch) are repeated multiple times, may be used.

An edge region near the end surface (side surface) 1c of the underlying substrate 1 on the first surface 1a of the underlying substrate 1 may be also covered by the mask 6 described above in consideration of ease of peeling and separating the plurality of semiconductor layers 3, which will be described below. As a result, a semiconductor layer near the edge portion, which is located at the end of the underlying substrate 1, can be easily peeled off.

Subsequently, as illustrated in FIG. 6B, each semiconductor element layer 8, which is a crystal growth layer of a semiconductor, is vapor phase grown from the first surface 1a exposed from the opening portion 7. The semiconductor element layer 8 is a nitride semiconductor layer in the present embodiment, but other materials may be used.

As a method of crystal growth, vapor phase epitaxy (VPE) by a chloride transport method using a chloride as a group III raw material, or metal organic chemical vapor deposition (MOCVD) using an organic metal as a group III raw material can be used. The ratio of raw material gas of a group III element, the ratio of raw material gas of an impurity, and the like can be changed during the growth step, and thus the semiconductor element layer 8 can be formed as a multi-layer film functioning as the semiconductor element 33 such as an LED or an LD.

When the crystal is grown beyond the opening portion 7 of the mask 6, the crystal is also grown in the lateral direction along the upper surface of the mask 6. The crystal growth is completed before the semiconductor crystal grown from the first surface 1a overlaps with an adjacent semiconductor crystal. In this manner, the semiconductor element layer 8 is obtained by growing the nitride semiconductor by the ELO method. The width of the semiconductor element layer 8 is, for example, approximately from 50 µm to 200 µm, and the height thereof is approximately from 10 µm to 50 µm.

For example, after an adhesive layer 9 being a metal layer is formed, the underlying substrate 1 and the mask 6, the semiconductor element layer 8, and the adhesive layer 9 formed on or above the underlying substrate 1 are immersed in BHF for approximately 10 minutes and thus the mask 6 is removed. As a result, as illustrated in FIG. 6C, the semiconductor element 33 is formed above the underlying substrate 1. Each semiconductor element 33 and the underlying substrate 1 are connected to the underlying substrate 1 via the connecting portion 2 having a columnar shape, which is a part of the semiconductor element layer 8 grown in the opening portion 7 of the mask 6. The adhesive layer 9 can be used as an electrode of the semiconductor element 33.

Note that, depending on the configuration of the semiconductor element 33, the adhesive layer 9 does not need to be necessarily used as the electrode. The semiconductor element layer 8 has an upper surface 8a and a lower surface 8b located on the opposite side of the upper surface 8a. The mask 6 may be removed either before or after the connection of the semiconductor element 33 and the support substrate 10 as described below, and at least a part of the adhesive layer 9 may be corroded and dissolved by BHF. The adhesive layer 9 may bond the upper surface of the semiconductor element 33 to the support substrate 10. Alternatively, the adhesive layer 9 may be used as a metal layer also serving as an electrode of the semiconductor element 33 after being subjected to corrosion prevention.

Next, as illustrated in FIG. 6C, in the light irradiation step, the connecting portion 2 is brought into contact with the etching solution 4, and the connecting portion 2 or the periphery of the connecting portion 2 is irradiated with light (laser beam 5 in this example) having a wavelength in which dissolution caused by a photochemical reaction occurs, and thus the connecting portion 2 is dissolved or weakened.

Here, for example, light emitted from an LED or a halogen lamp may be used instead of the laser beam 5. Note that, in order to obtain the wavelength selectivity and the high reaction rate of the photochemical reaction, the laser beam 5 with which a minute region can be irradiated with high intensity is preferably used.

Irradiation of the laser beam 5 may be performed on a part of the connecting portion 2 closer to the semiconductor element 33 or a region including a part of the connecting portion 2 closer to the semiconductor element 33. In this case, when a part of the connecting portion 2 closer to the semiconductor element 33 is separated from the underlying substrate 1, the separation can be performed such that a projecting structure or the like is not left on the semiconductor element 33, thereby reducing restrictions in the step of mounting the semiconductor element 33 after the separation.

Irradiation with the laser beam 5 may be performed on a part of the connecting portion 2 closer to the underlying substrate 1 or a region including a part of the connecting portion 2 closer to the underlying substrate 1. By limiting the region irradiated with the laser beam 5 in this manner, influence of thermal shock or the like on the semiconductor element 33 can be reduced, and high accuracy alignment is not necessary for the focal position control of the laser beam 5.

Irradiation with the laser beam 5 can be also performed on an intermediate portion located between the end portion of the connecting portion 2 closer to the underlying substrate 1 and the end portion of the connecting portion 2 closer to the semiconductor element 33. This enables minimization of a region to be etched, low-power output of the laser beam 5, reduce the etching time, and improvement of the productivity.

Further, scanning with the laser beam 5 may be performed in any direction within the substrate surface of the underlying substrate 1 while the laser beam 5 is focused on the position described above. In this case, other light sources such as those described above may be also used instead of the laser beam 5.

The technique of irradiating the connecting portion 2 with the laser beam 5 in a state where the connecting portion 2 is in contact with an etching solution, which is an electrolytic solution, is also referred to as photo-electrochemical (PEC) etching. In the PEC etching, when a semiconductor (GaN) is irradiated with the laser beam in the etching solution, an "oxidation reaction" represented by the following equation (1) and an "oxide film dissolution reaction" represented by the following equation (2) occur. Here, "h⁺" in Equation (1) represents a positive hole.

Oxidation Reaction

2GaN + 6OH⁻ + 6h⁺ → Ga₂O₃ + 3H₂O + N₂ ... (1)

Dissolution Reaction

Ga₂O₃ + 6OH⁻ → 2GaO₃³⁻ + 3H₂O ... (2)

Due to the oxidation reaction and the oxidation film dissolution reaction described above, when the connecting portion 2 is irradiated with the laser beam 5 in the etching solution 4, an electric field is generated from the inside toward the surface of the connecting portion 2, and the connecting portion 2 is dissolved from the surface in acid or alkali or weakened.

Such PEC etching is photo-induced etching capable of etching only a layer containing photogenerated carriers. Thus, the rate of etching due to the oxidation reaction occurring on the semiconductor surface is controlled based on the amount of passing charge, so that damage can be decreased.

The photo carriers (positive holes) generated in the GaN layer flow into the etching solution, and are used in the etching reaction as described above. Thus, when the GaN layer is thinned by etching, the number of carriers decreases, and a reaction current path is completely blocked by the depletion of a current supply path in the semiconductor, and thus the etching reaction is self-terminated. By this self-termination, a process margin is increased, and a decrease in yield due to process variations within the substrate and between lots is reduced.

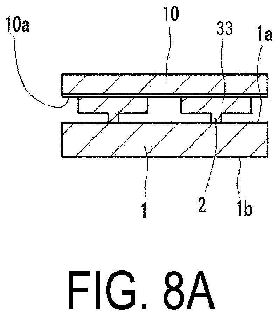

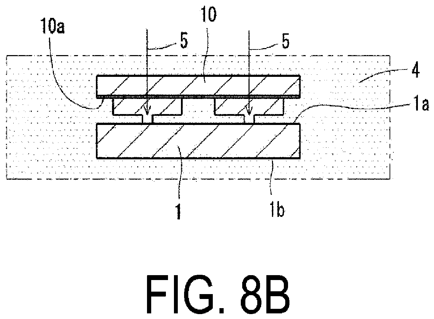

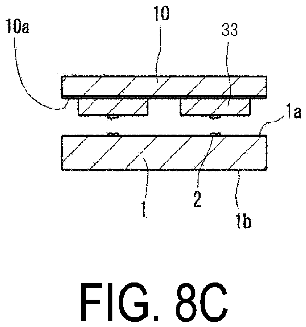

As illustrated in FIGs. 8A, 8B, and 8C, the support substrate 10 is connected to each semiconductor element 33, the connecting portion 2 of which is irradiated with the laser beam 5, by using a substrate bonding apparatus (not illustrated). When the support substrate 10 is connected to the semiconductor element 33, the underlying substrate 1 and the support substrate 10 are attached to the substrate bonding apparatus so that the first surface 1a of the underlying substrate 1 and the facing surface 10a of the support substrate 10 are parallel to each other.

Subsequently, the facing surface 10a of the support substrate 10 and an upper surface of the semiconductor element 33 (upper surface of the adhesive layer 9) are brought into contact with each other. The support substrate 10 is pressed, and the adhesive layer 9 is brought into close contact with and pressed against the support substrate 10. Then, the adhesive layer 9 and the support substrate 10 are heated to 300°C and, for example, AuSn bonding is performed. Thus, as illustrated in FIG. 8A, the support substrate 10 is bonded to the semiconductor element 33. The bonding is not limited to AuSn bonding, but various bonding methods using other materials are possible.

As illustrated in FIG. 8B, the connecting portion 2 is, for example, weakened by being irradiated with the laser beam as described above. After cooling the substrate bonding apparatus, the underlying substrate 1 is taken out from the substrate bonding apparatus, and the support substrate 10 is moved in a direction away from the underlying substrate 1. As a result, a large tensile stress is generated in the connecting portion 2 weakened by the irradiation with the laser beam 5, and the connecting portion 2 is broken as illustrated in FIG. 8C. At this time, the connecting portion 2 is in a weakened state or the like, and thus the underlying substrate 1 can be easily separated. The separation can be performed by an appropriate method. The connecting portion 2 may remain on the underlying substrate 1, on the semiconductor element 33, or on both of them, depending on the weakened location. Thus, after the separation, a remaining piece of the connecting portion 2 remaining on the semiconductor element 33 is removed by polishing or the like.

As described above, since the connecting portion 2 between the semiconductor element 33 and the underlying substrate 1 is dissolved or weakened, the risk of generation of cracks and crystal defects due to the separating step can be reduced. This enables the underlying substrate 1 to have a large diameter and can improve the yield of the separating step. In the separating step, a rough surface region including a plurality of crystal surfaces may be formed on at least one selected from the group consisting of the semiconductor element 33 and the underlying substrate 1. This makes it difficult for cracks to be generated or propagated when the semiconductor element 33 is separated from the underlying substrate 1.

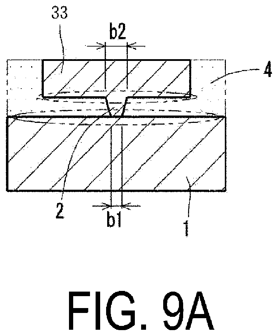

FIGs. 9A to 9C are views illustrating etching shapes of the connecting portion. When the connecting portion 2 is irradiated with the laser beam 5 from the side, an electric field in an arrow E direction is generated from the underlying substrate 1 toward the semiconductor element 33, and the first surface 1a of the underlying substrate 1 is polarized as a Ga-polar surface and a facing surface 3a of the semiconductor element 33 facing the underlying substrate 1 is polarized as an N-polar surface. Thus, the oxidation of the first surface 1a, which is the Ga polar surface, is promoted more than the oxidation of the facing surface 3a, which is the N polar surface, and the etching of the first surface 1a progresses faster. Thus, as illustrated in FIG. 9A, the connecting portion 2 is etched to have an inverted trapezoidal shape in cross section in which a width b1 of a part of the connecting portion 2 closer to the underlying substrate 1 is smaller, and a width b2 of a part of the connecting portion 2 closer to the semiconductor element 33 is larger.

When the electron density is 3 × 10¹⁷ cm⁻³, the inventors of the present disclosure have confirmed that when the test sample of GaN is immersed in an etching solution of KOH having pH 13 and is irradiated with a HeCd laser beam having a wavelength λ of 325 nm, an etching rate of 525 nm/min can be obtained, for example.

In the present embodiment, the semiconductor element layer 8 is made of a material having a band structure producing an energy barrier, such as n-GaN/i-GaN/n-GaN. Then, a selective region is irradiated with the laser beam, and polarization or the like due to optical excitation, a current circuit, and electric field distortion occurs. Thus, the connecting portion 2 or a part thereof can be selectively etched by an etchant such as KOH and TMAH capable of promoting chemical etching reaction of the charge localized portion.

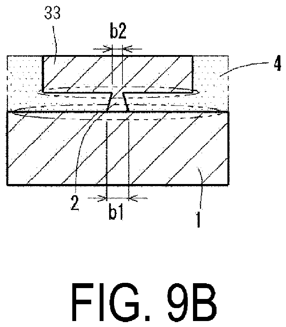

In the present embodiment, the connecting portion 2 is structured to have pores by a void-assisted separation (VAS) method, formation of coarse initial nucleus, porosification by anodization, In-droplet method, or the like. This increases the surface area and reduces the stiffness as compared with an ELO structure without pores. At the same time, selective weakening is possible by increasing the etching rate. For example, as illustrated in FIG. 9B, the connecting portion 2 can be etched to have a trapezoidal shape in cross section in which the width b2 of a part of the connecting portion 2 closer to the semiconductor element 33 is smaller and the width b1 of a part of the connecting portion 2 closer to the underlying substrate 1 is larger.

By performing control of the porosities (pore densities) of a part of the connecting portion 2 closer to the semiconductor element 33 and a part of the connecting portion 2 closer to the underlying substrate 1, the etching rate can be controlled, and the width b1 and the width b2 can also be controlled. Accordingly, the etching rate of the connecting portion 2 can be changed to achieve width b1 > width b2. In particular, an interface (initial growth layer of the ELO structure) between the connecting portion 2 and the underlying substrate 1 can easily have pores by the epitaxial growth conditions, the VAS method, or the like.

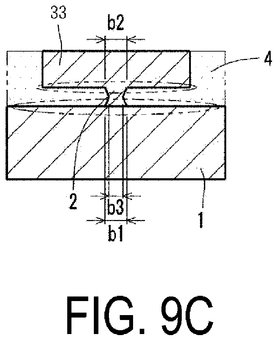

As illustrated in FIG. 9C, the intermediate portion between the end portion of the connecting portion 2 closer to the underlying substrate 1 and the end portion of the connecting portion 2 closer to the semiconductor element 33, more specifically, a width b3 of the central portion can also be smaller than the widths b1 and b2 of both ends of the connecting portion 2. Thus, a high operability of a portion to be weakened can be achieved. For example, control of the electron concentration difference between the connecting portion 2 and the semiconductor element 33 and the underlying substrate 1 sandwiching the connecting portion 2 can also achieve the change in the etching rate of the connecting portion 2, thereby satisfying the relationship of width b1, width b2 > width b3. Alternatively, a layer having a different band gap by heteroepitaxial growth may be inserted, or a stress layer generating strain may be inserted at an interface between the connecting portion 2 and the semiconductor element 33 or an interface between the underlying substrate 1 and the connecting portion 2. Thus, the etching rate can be controlled. Alternatively, the inside of the connecting portion 2 may have a multilayer structure as described above, and thus the etching rate can be controlled.

As described above, according to the manufacturing method of the semiconductor element of the present embodiment, in addition to weakening or the like of the connecting portion, the support substrate is used. This can reduce the risk of generation of cracks and crystal defects due to the separating step, enable the underlying substrate to have a large diameter, and improve the yield of the separating step.

The manufacturing method of the semiconductor element of the present disclosure includes an element forming step of forming a semiconductor element located above an underlying substrate via a connecting portion, a light irradiation step of irradiating the connecting portion with light in a state where the connecting portion is in contact with the etching solution to dissolve or weaken the connecting portion, and a separating step of separating the semiconductor element from the underlying substrate.

In the related art as described in PTL 1, when cracks and crystal defects are generated in both the semiconductor element and the underlying substrate, the characteristics of the semiconductor element and the yield in the manufacturing may deteriorate. Thus, the manufacturing method of the semiconductor element is demanded in which the generation of cracks and crystal defects in both the semiconductor element and the underlying substrate can be reduced, and the characteristics of the semiconductor element and the yield in the manufacturing are less likely to deteriorate.

The manufacturing method of the semiconductor element of the present disclosure can reduce the generation of cracks and crystal defects due to the separating step and enables the underlying substrate to have a large diameter. This can improve the yield of the separating step and thus improve the productivity.

### Third Embodiment

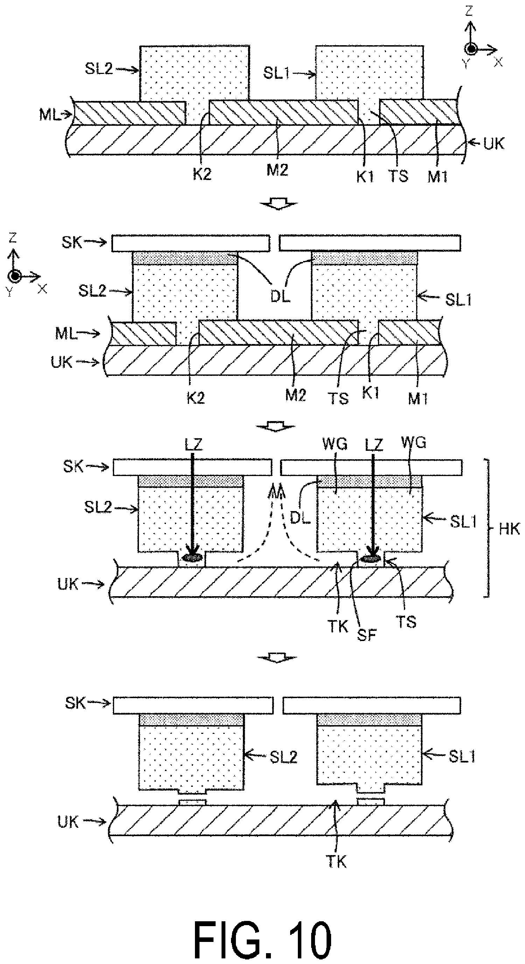

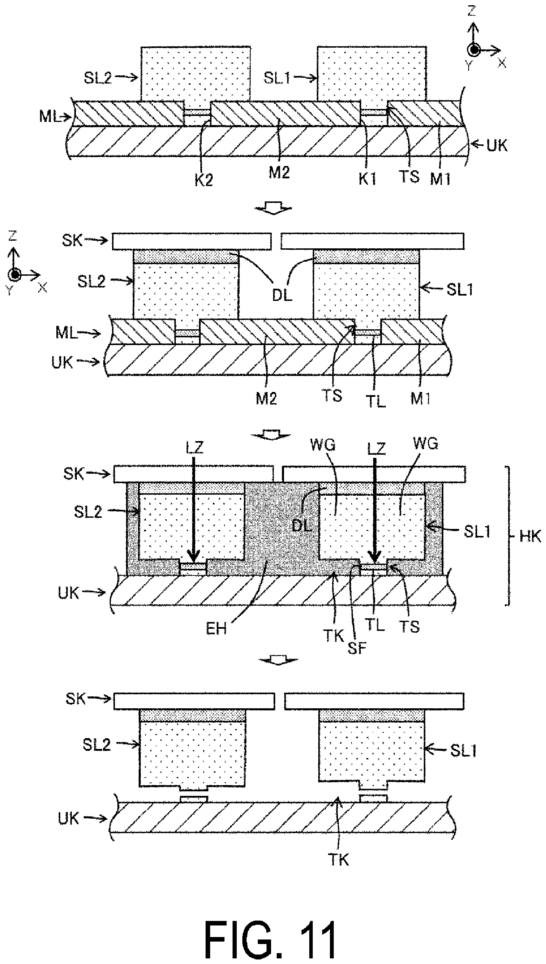

FIGs. 10 and 11 are cross-sectional views illustrating a manufacturing method of a manufacturing method of a plurality of semiconductor elements according to a third embodiment. As illustrated in FIGs. 10 and 11, the manufacturing method of the plurality of semiconductor elements according to the third embodiment includes a step of forming a semiconductor substrate HK including an underlying substrate UK and a first semiconductor part SL1 having a layered shape and bonded to the underlying substrate UK, and a step of separating the first semiconductor part SL1 from the underlying substrate UK. The first semiconductor part SL1 contains a nitride semiconductor. The first semiconductor part SL1 may be a first semiconductor layer.

The first semiconductor part SL1 includes a protruding portion TS protruding toward the underlying substrate UK, and the protruding portion TS contains a nitride semiconductor. The protruding portion TS is located in a center of the first semiconductor part SL1 in a plan view, and has a longitudinal shape. The protruding portion TS and the underlying substrate UK are bonded to each other, and a hollow portion TK located between the underlying substrate UK and the first semiconductor part SL1 is formed on the semiconductor substrate HK. The hollow portion TK is in contact with a side surface SF of the protruding portion TS, communicates with the outside of the semiconductor substrate HK, and can serve as a channel for gas and liquid.

Specific examples of the nitride semiconductor include a GaN-based semiconductor, aluminum nitride (AlN), indium aluminum nitride (InAlN), and indium nitride (InN). A Z direction is the normal direction of the (0001) plane, which is the c-plane of the nitride semiconductor of the protruding portion TS. An X direction is the normal direction of the (11-20) plane, which is the a-plane of the nitride semiconductor of the protruding portion TS, and a Y direction is the normal direction of the (1-100) plane, which is the m-plane of the nitride semiconductor of the protruding portion TS.

In FIG. 10, before the first semiconductor part SL1 is separated from the underlying substrate UK, the protruding portion TS is irradiated with a laser beam (laser ablation). On the other hand, in FIG. 11, before the first semiconductor part SL1 is separated, an etching liquid EH is injected into the hollow portion TK and the protruding portion TS is irradiated with a laser beam (photoexcitation).

In the third embodiment, as illustrated in FIGs. 10 and 11, the first semiconductor part SL1 is formed, by the epitaxial lateral overgrowth (ELO) method, on a mask ML located on the underlying substrate UK and including mask portions M1 and M2 and opening portions K1 and K2. Then, the mask portions M1 and M2 are etched, and the hollow portions TK are formed. The mask ML may be a mask layer. The protruding portion TS is formed in the opening portion K1. The protruding portion TS may have a shape in which the <1-100> direction (Y direction) of the nitride semiconductor contained in the protruding portion TS is a longitudinal direction.

The first semiconductor part SL1 includes a low dislocation portion WG not overlapping with the protruding portion TS in a plan view and having a threading dislocation density that is 1/5 or less of that of the protruding portion TS. The semiconductor substrate HK includes a second semiconductor part SL2. The first semiconductor part SL1 and the second semiconductor part SL2 are aligned in the <11-20> direction (X direction) of the nitride semiconductor. The second semiconductor part SL2 may be a second semiconductor layer. The semiconductor substrate HK includes a device portion DL formed on the first semiconductor part SL1. Although not illustrated, the device portion DL includes, for example, a p-type semiconductor part, an n-type semiconductor part, an active portion including a light-emitting region, and an electrode portion. The p-type semiconductor part, the n-type semiconductor part, the active portion, and the electrode portion are each formed in a layered shape, and are layered to form the device portion DL. In other words, the device portion DL may be a device layer. The light-emitting region can be formed so as to overlap with the low dislocation portion WG in a plan view.

As illustrated in FIGs. 10 and 11, the semiconductor substrate HK may include a support substrate SK facing the underlying substrate UK, and the first semiconductor part SL1 may be located between the underlying substrate UK and the support substrate SK. The electrode portion of the device portion DL and the support substrate SK may be bonded.

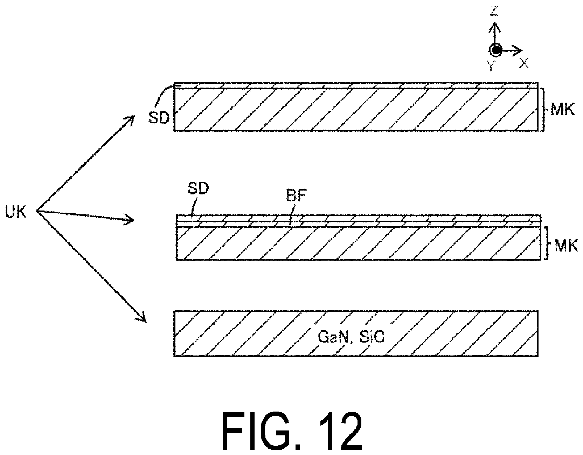

FIG. 12 is a cross-sectional view illustrating a configuration example of the underlying substrate. As illustrated in FIG. 12, the nitride semiconductor contained in the protruding portion TS may be a GaN-based semiconductor, and the underlying substrate UK may include a dissimilar substrate MK and a seed portion SD, the dissimilar substrate MK having a lattice constant different from that of the GaN-based semiconductor of the protruding portion TS, the seed portion SD being formed on the dissimilar substrate MK and containing a nitride semiconductor. In this case, the underlying substrate UK may include a main substrate MK being a silicon substrate, and a seed portion SD (for example, AlN portion), or may include a main substrate MK being a silicon carbide substrate, and a seed portion SD (for example, a GaN-based semiconductor part). The underlying substrate UK may include a main substrate MK being a silicon substrate, a buffer portion BF (for example, including at least one selected from the group consisting of an AlN portion and an SiC portion) on the main substrate, and a seed portion SD (for example, a GaN-based semiconductor part) on the buffer portion. Note that the underlying substrate UK is not limited to these configurations, and may be a bulk type GaN substrate or a bulk type SiC substrate (hexagonal system). The seed portion SD may be a seed layer, and the buffer portion BF may be a buffer layer.

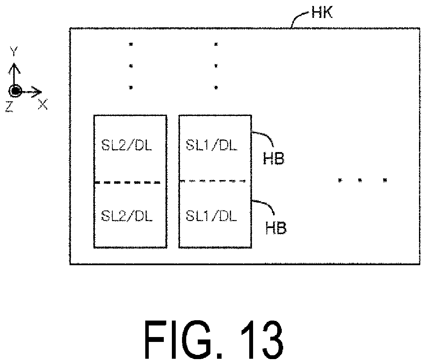

FIG. 13 is a plan view illustrating a configuration example of the semiconductor substrate. As illustrated in FIG. 13, in the semiconductor substrate HK, the first semiconductor part SL1 and the device portion DL may be divided into a plurality of semiconductor element portions HB. Each semiconductor element portion HB functions as, for example, a light emitting diode (LED) or a semiconductor laser.

In FIG. 10, after the formation of the semiconductor substrate HK, the irradiation with the laser beam LZ causes laser ablation in the protruding portion TS containing a nitride semiconductor, thus weakening or laterally cutting (cutting in parallel to the c-plane) the protruding portion TS. The width (size in the X direction) of the protruding portion TS is smaller than the width of the first semiconductor part SL1, which facilitates the step (weakening or cutting) when the first semiconductor part SL1 is separated from the underlying substrate UK. The gas (decomposition product) generated by the laser ablation is released to the outside of the semiconductor substrate HK through the hollow portion TK. For example, a nanosecond pulse laser beam can be used as the laser beam.

In FIG. 11, after the formation of the semiconductor substrate HK, the protruding portion TS is irradiated with the laser beam LZ while the etching liquid EH is in contact with the side surface of the protruding portion TS. Thus, anisotropic etching proceeding from the side surface to the inner portion of the protruding portion TS is performed. Specifically, the nitride semiconductor (for example, GaN-based semiconductor) of the protruding portion TS is converted into an oxide (for example, Ga₂O₃) using positive holes generated by photoexcitation and anions (for example, hydroxide ions) of the etching solution EH, and the oxide is ionized and dissolved in the etching solution EH. Thus, the protruding portion TS is weakened or laterally cut (cut in parallel to the c-plane). The width of the protruding portion TS is smaller than the width of the first semiconductor part SL1, which facilitates the step (weakening or cutting) when the first semiconductor part SL1 is separated from the underlying substrate UK.

Electron-hole pairs are generated in the protruding portion TS by the irradiation with the laser beam LZ, the positive holes are used for oxidation of the nitride semiconductor, and the electrons are consumed in the reaction in the etching solution EH (an electrode may be provided in the etching solution EH but the present embodiment is not limited thereto). By performing anisotropic wet etching as illustrated in FIG. 11, the protruding portion TS can be etched while etching progress (damage to the low dislocation portion WG) in the Z direction is suppressed.

In FIG. 11, the protruding portion TS may include a target portion TL in which the etching preferentially progresses. The target portion TL may be a target layer. The nitride semiconductor (for example, GaN-based semiconductor) contained in the target portion TL can have a band gap smaller than those of nitride semiconductors contained in upper and lower adjacent portions. In this case, the laser beam LZ can be UV light having energy larger than the band gap of the nitride semiconductor contained in the target portion TL. As such a UV laser, for example, a HeCd laser having a wavelength of 325 nm can be used.

The target portion TL may contain indium and gallium (as an example, an InGaN layer). The target portion TL may have a higher porosity and lower stiffness than the upper and lower adjacent portions. The target portion TL does not need to be provided in the middle of the protruding portion TS, and may be provided so as to include a root portion or a distal end portion (a portion coupled to the underlying substrate UK) of the protruding portion TS.

In the third embodiment, the step of separating the first semiconductor part SL1 from the underlying substrate UK may be a step performed after the weakening of the protruding portion TS, or may be a step of laterally cutting the protruding portion TS. Irradiation of the laser beam LZ may be performed from a direction of the underlying substrate UK or may be performed from a direction of the support substrate SK, but the latter is selected when the underlying substrate UK has a light shade property (for example, when including a silicon substrate).

In the third embodiment, the step of forming the semiconductor substrate HK including the underlying substrate UK and the first semiconductor part (semiconductor layer) SL1 bonded to the underlying substrate UK, and the step of separating the first semiconductor part (semiconductor layer) SL1 from the underlying substrate UK can be performed. Here, the first semiconductor part (semiconductor layer) SL1 can include the protruding portion TS protruding toward the underlying substrate UK, the protruding portion TS can contain a nitride semiconductor, the protruding portion TS and the underlying substrate UK can be bonded to each other, the hollow portion TK located between the underlying substrate UK and the first semiconductor part (semiconductor layer) SL1 can be formed on the semiconductor substrate HK, and the hollow portion TK can be in contact with the side surface of the protruding portion TS and communicate with the outside of the semiconductor substrate HK. Before the first semiconductor part (semiconductor layer) SL1 is separated, at least one selected from the group consisting of irradiation of the protruding portion TS with the laser beam and injection of the etching liquid into the hollow portion TK can be performed.

### Supplementary Note

While the manufacturing method of the semiconductor element according to the present disclosure has been described above in detail, the present disclosure is not limited to the aforementioned embodiments, and various changes, improvements, and the like can be made without departing from the gist of the present disclosure.

For example, in the first embodiment, an example has been described in which the GaN substrate is adopted as the underlying substrate, but as described in the second and third embodiments, the underlying substrate containing a material different from the semiconductor material contained in each of the plurality of semiconductor layers 3 may be employed. In this case, for example, the underlying substrate may be made of sapphire (Al₂O₃), silicon carbide (SiC), silicon (Si), or the like. In this case, the buffer portion and the seed portion may be disposed on the underlying substrate.

For example, an example has been described above in which after the mask is removed, irradiation with the laser is performed, but the mask may be removed after the irradiation with the laser and before peeling off of the plurality of semiconductor layers 3.

### REFERENCE SIGNS

1 Underlying substrate
1a One main surface (first surface)
1b Another main surface (second surface)
1c Side surface (third surface), end surface
2 Connecting portion
21, 22 End portion
23 Intermediate portion
3 Semiconductor layer
4 Etching solution
5 Laser beam
6 Deposition suppression mask (mask)
6a Strip shape portion
7 Opening portion
8 Semiconductor element layer
8a Upper surface
8b Lower surface
9 Adhesive layer
10 Support substrate
10a Facing surface
10b Bonding layer
33 Semiconductor element
61 Strip shape portion
62 Opening portion
G Gap (release path)
S Semiconductor element
a Forming step
a1 Mask forming step
a2 Semiconductor layer forming step
a3 Mask removing step
b Weakening step
c Separating step
c1 Preparing step
c2 Bonding step
c3 Peeling step
S1 Element forming step
S2 Light irradiation step
S3 Separating step

## Claims

1. A manufacturing method of a semiconductor element, the manufacturing method comprising:
preparing a plurality of semiconductor layers above a first surface of an underlying substrate by crystal growth, semiconductor layers adjacent to each other in a direction along the first surface among the plurality of semiconductor layers being at least partially separated from each other in the direction along the first surface;
irradiating a connecting portion between each of the plurality of semiconductor layers and the first surface with a laser beam; and
separating the plurality of semiconductor layers from the underlying substrate.

2. The manufacturing method of a semiconductor element according to claim 1, wherein
the underlying substrate, the connecting portion, and each of the plurality of semiconductor layers contain a nitride semiconductor.

3. The manufacturing method of a semiconductor element according to claim 2, wherein
the underlying substrate, the connecting portion, and each of the plurality of semiconductor layers contain a gallium nitride semiconductor.

4. The manufacturing method of a semiconductor element according to any one of claims 1 to 3, wherein
the laser beam is incident from a second surface of the underlying substrate on an opposite side of the first surface.

5. The manufacturing method of a semiconductor element according to any one of claims 1 to 4, wherein
the connecting portion is irradiated with a picosecond pulse laser beam or a femtosecond pulse laser beam.

6. The manufacturing method of a semiconductor element according to any one of claims 1 to 4, wherein
the connecting portion is irradiated with a subnanosecond pulse laser beam or a nanosecond pulse laser beam.

7. The manufacturing method of a semiconductor element according to any one of claims 1 to 6, wherein
scanning with the laser beam is performed from an outer peripheral portion of the underlying substrate toward a central portion of the underlying substrate while the underlying substrate rotates around an axis perpendicular to the first surface.

8. The manufacturing method of a semiconductor element according to any one of claims 1 to 7, wherein
the underlying substrate is heated or cooled, and thus a temperature of the underlying substrate is maintained within a predetermined temperature range.

9. The manufacturing method of a semiconductor element according to any one of claims 1 to 8, wherein
the laser beam is focused on an end portion of the connecting portion closer to the underlying substrate.

10. The manufacturing method of a semiconductor element according to any one of claims 1 to 8, wherein
the laser beam is focused on an end portion of the connecting portion closer to each of the plurality of semiconductor layers.

11. The manufacturing method of a semiconductor element according to any one of claims 1 to 8, wherein
the laser beam is focused on an intermediate portion of the connecting portion, the intermediate portion being located between an end portion of the connecting portion closer to the underlying substrate and an end portion of the connecting portion closer to each of the plurality of semiconductor layers.

12. The manufacturing method of a semiconductor element according to any one of claims 1 to 11, wherein
the separating of the plurality of semiconductor layers from the underlying substrate comprises
preparing a support substrate comprising a third surface facing the first surface of the underlying substrate,
bonding the third surface of the support substrate to a fourth surface of each of the plurality of semiconductor layers, the fourth surface being on an opposite side of a surface facing the first surface of the underlying substrate, and
relatively separating the underlying substrate and the support substrate to peel the plurality of semiconductor layers from the underlying substrate.

13. A manufacturing method of a semiconductor element, the manufacturing method comprising:
forming a semiconductor element located above an underlying substrate via a connecting portion;
irradiating the connecting portion with light in a state where the connecting portion is in contact with an etching solution; and
separating the semiconductor element from the underlying substrate.

14. The manufacturing method of a semiconductor element according to claim 13, wherein
the forming of the semiconductor element and the irradiating with the light are performed in parallel.

15. The manufacturing method of a semiconductor element according to claim 13 or 14, wherein
in the irradiating with the light, a laser beam is used as the light, and at least a part of the connecting portion is irradiated with the laser beam.

16. The manufacturing method of a semiconductor element according to claim 15, wherein
the irradiating with the light comprises performing scanning with the laser beam in any direction within a substrate surface of the underlying substrate.

17. The manufacturing method of a semiconductor element according to any one of claims 13 to 16, the manufacturing method further comprising
before or after the forming of the semiconductor element, preparing a support substrate comprising a facing surface facing the underlying substrate, and
before the irradiating with the light, bonding the support substrate to the semiconductor element by performing heating or light irradiation while at least one selected from the group consisting of the support substrate and the underlying substrate is pressed such that pressure is applied between the support substrate and the underlying substrate in a state in which the support substrate is disposed on the semiconductor element formed in the forming of the semiconductor element such that the facing surface faces the underlying substrate.

18. The manufacturing method of a semiconductor element according to any one of claims 13 to 17, wherein
in the separating, a rough surface region comprising a plurality of crystal surfaces is formed at at least one selected from the group consisting of the semiconductor element and the underlying substrate.

19. A manufacturing method of a semiconductor element, the manufacturing method comprising:
preparing a semiconductor substrate comprising an underlying substrate and a first semiconductor part connected to the underlying substrate at a part; and
separating the first semiconductor part from the underlying substrate, wherein
when or before the first semiconductor part is peeled off, the part of the first semiconductor part is irradiated with a laser beam.

20. The manufacturing method of a semiconductor element according to claim 19, wherein
before the first semiconductor part is peeled off, a hollow portion communicating with an outside of the semiconductor substrate is formed between the underlying substrate and the first semiconductor part.

21. The manufacturing method of a semiconductor element according to claim 20, wherein
the first semiconductor part comprises a protruding portion, the protruding portion containing a nitride semiconductor, protruding toward the underlying substrate, and being bonded to the underlying substrate,
the hollow portion is in contact with a side surface of the protruding portion, and
an etching liquid is injected into the hollow portion before the first semiconductor part is separated.

22. The manufacturing method of a semiconductor element according to claim 21, wherein
the first semiconductor part is formed, by an ELO method, on a mask located on the underlying substrate and comprising a mask portion and an opening portion, and then the hollow portion is formed by removal of the mask portion.

23. The manufacturing method of a semiconductor element according to claim 22, wherein
the protruding portion is formed in the opening portion.

24. The manufacturing method of a semiconductor element according to any one of claims 21 to 23, wherein
the protruding portion has a shape in which a longitudinal direction is a <1-100> direction of the nitride semiconductor.

25. The manufacturing method of a semiconductor element according to any one of claims 21 to 24, wherein
the first semiconductor part comprises a low dislocation portion not overlapping with the protruding portion in a plan view, the low dislocation portion having a threading dislocation density that is 1/5 or less of a threading dislocation density of the protruding portion.

26. The manufacturing method of a semiconductor element according to any one of claims 21 to 25, wherein
the semiconductor substrate comprises a second semiconductor part, and
the first semiconductor part and the second semiconductor part are aligned in a <11-20> direction of the nitride semiconductor.

27. The manufacturing method of a semiconductor element according to any one of claims 19 to 26, wherein
the semiconductor substrate comprises a device portion formed on the first semiconductor part.

28. The manufacturing method of a semiconductor element according to claim 27, wherein
in the semiconductor substrate, the first semiconductor part and the device portion are divided into a plurality of semiconductor element portions.

29. The manufacturing method of a semiconductor element according to any one of claims 19 to 28, wherein
the semiconductor substrate comprises a support substrate facing the underlying substrate, and the first semiconductor part is located between the underlying substrate and the support substrate.

30. The manufacturing method of a semiconductor element according to any one of claims 21 to 26, wherein
the nitride semiconductor is a GaN-based semiconductor, and
the underlying substrate comprises
a dissimilar substrate different in a lattice constant from the GaN-based semiconductor, and
a seed portion formed on the dissimilar substrate and containing a nitride semiconductor.

31. The manufacturing method of a semiconductor element according to any one of claims 21 to 26, wherein
irradiation with the laser beam causes laser ablation at the protruding portion, and
gas generated by the laser ablation is released to an outside of the semiconductor substrate through the hollow portion.

32. The manufacturing method of a semiconductor element according to any one of claims 21 to 26, wherein
the protruding portion is irradiated with the laser beam while the etching liquid is in contact with the side surface of the protruding portion and thus anisotropic etching proceeding from the side surface to an inner portion of the protruding portion is performed.

33. The manufacturing method of a semiconductor element according to claim 32, wherein
the nitride semiconductor of the protruding portion is converted into an oxide by using positive holes generated by photoexcitation and anions of the etching liquid, and the oxide is dissolved in the etching liquid.

34. The manufacturing method of a semiconductor element according to claim 32 or 33, wherein
the protruding portion comprises a target portion, and etching preferentially progresses at the target portion.

35. The manufacturing method of a semiconductor element according to claim 34, wherein
a nitride semiconductor contained in the target portion has a band gap smaller than band gaps of nitride semiconductors contained in upper and lower adjacent portions.

36. The manufacturing method of a semiconductor element according to claim 35, wherein
the laser beam is UV light having energy larger than the band gap of the nitride semiconductor contained in the target portion.

37. The manufacturing method of a semiconductor element according to claim 35 or 36, wherein
the target portion contains indium and gallium.

38. The manufacturing method of a semiconductor element according to claim 34, wherein
the target portion has a higher porosity than the upper and lower adjacent portions.
